# EUROPEAN PATENT APPLICATION

(11) **EP 4 772 967 A1**
(43) Date of publication of application: **08.07.2026**
(21) Application number: 23962714.4
(22) Date of filing: 28.12.2023
(51) Int. Cl.: G06F 3/01

(54) **HAPTIC FEEDBACK ASSEMBLY AND HAPTIC FEEDBACK DEVICE**

(71) Applicant: Boe Technology Group Co., Ltd., Beijing 100015 (CN); Beijing BOE Technology Development Co., Ltd., Daxing District Beijing 100176 (CN)
(72) Inventor: HUANG, Jijing, Beijing 100176 (CN); WANG, He, Beijing 100176 (CN); QI, Dexing, Beijing 100176 (CN)
(74) Representative: Cohausz & Florack
(86) International application number: PCT/CN2023/142933
(87) International publication number: WO 2025/138035

(57) **Abstract**

Embodiments of the present disclosure provide a haptic feedback assembly and a haptic feedback device. The haptic feedback assembly includes: a flexible circuit board, where the flexible circuit board includes a flexible substrate, a first metal layer arranged on a side of a first surface of the flexible substrate, and a second metal layer arranged on a side of a second surface of the flexible substrate, and the first surface and the second surface are oppositely arranged in a thickness direction of the flexible substrate; and a plurality of piezoelectric actuators, arranged on a side of the first metal layer away from the flexible substrate, where the piezoelectric actuators are electrically connected with the first metal layer, the first metal layer is electrically connected with the second metal layer through a through hole penetrating the flexible substrate, the second metal layer is electrically connected with an external driving circuit.

## Description

### Technical Field

The present disclosure relates to the technical field of haptic feedback, and in particular to a haptic feedback assembly and a haptic feedback device.

### Background

Haptics is the focus of today's technological development. Haptics can enable a terminal to interact with a human body through sense of touch.

### Summary

Embodiments of the present disclosure provide a haptic feedback assembly and a haptic feedback device, and specific schemes are as follows.

A haptic feedback assembly according to embodiments of the present disclosure includes:
a flexible circuit board, including a flexible substrate, a first metal layer on a side of a first surface of the flexible substrate, and a second metal layer on a side of a second surface of the flexible substrate; where the first surface and the second surface are oppositely arranged along a thickness direction of the flexible substrate; and
a plurality of piezoelectric actuators, on a side of the first metal layer away from the flexible substrate, where the piezoelectric actuators are electrically connected with the first metal layer, the first metal layer is electrically connected with the second metal layer through a through hole penetrating the flexible substrate, and the second metal layer is electrically connected with an external driving circuit; where the piezoelectric actuators are configured to generate haptic feedback in response to a driving signal input by the external driving circuit.

In a possible implementation, a side of the piezoelectric actuator facing the flexible circuit board is provided with an anode leading-out structure and a cathode leading-out structure;
the first metal layer includes a plurality of anode pads, a plurality of cathode pads, an anode wire and a cathode wire, the anode leading-out structure is electrically connected with the anode pad, the cathode leading-out structure is electrically connected with the cathode pad, the anode pad is electrically connected with the anode wire, and the cathode pad is electrically connected with the cathode wire.

In a possible implementation, the second metal layer includes an anode leading-out wire, a cathode leading-out wire, an anode input pad and a cathode input pad; where the anode wire is electrically connected with the anode leading-out wire, the cathode wire is electrically connected with the cathode leading-out wire, the anode leading-out wire is electrically connected with the anode input pad, the anode input pad is electrically connected with the external driving circuit, the cathode leading-out wire is electrically connected with the cathode input pad, and the cathode input pad is electrically connected with the external driving circuit.

In a possible implementation, the plurality of anode pads are sequentially arranged on the first surface of the flexible substrate along a length direction of the flexible substrate, and the plurality of cathode pads are sequentially arranged on the first surface of the flexible substrate along the length direction of the flexible substrate.

In a possible implementation, the plurality of anode pads and the plurality of cathode pads are located in different rows and arranged in parallel, or the plurality of anode pads and the plurality of cathode pads are located in the same row.

In a possible implementation, the anode pads and the cathode pads are alternately arranged along the length direction of the flexible substrate, and each of the piezoelectric actuators covers one of the anode pads and one of the cathode pads adjacent to each other, where the one of the anode pads and the one of the cathode pads are adjacent to each other.

In a possible implementation, the anode input pad and the cathode input pad are located at the same end of the flexible substrate.

In a possible implementation, all of the cathode pads are electrically connected with the same cathode wire, one end of the cathode wire close to the cathode input pad is electrically connected with one end of the cathode leading-out wire through a through hole penetrating the flexible substrate, and the other end of the cathode leading-out wire extends along the length direction of the flexible substrate to be electrically connected with the cathode input pad.

In a possible implementation, all of the anode pads are electrically connected with the same anode wire, one end of the anode wire close to the anode input pad is electrically connected with one end of the anode leading-out wire through a through hole penetrating the flexible substrate, and the other end of the anode leading-out wire extends along the length direction of the flexible substrate to be electrically connected with the anode input pad.

In a possible implementation, the plurality of anode pads are divided into at least two groups of anode pads along the length direction of the flexible substrate, each group of anode pads is electrically connected with the same anode wire, and different groups of anode pads are electrically connected with different cathode wires.

In a possible implementation, the plurality of anode pads are divided into a first group of anode pads and a second group of anode pads along the length direction of the flexible substrate, the anode wire includes a first anode wire and a second anode wire, the anode leading-out wire includes a first anode leading-out wire and a second anode leading-out wire, and the anode input pad includes a first anode input pad and a second anode input pad;
each anode pad in the first group of anode pads is electrically connected with the first anode wire, the first anode wire is electrically connected with one end of the first anode leading-out wire through a through hole, in a middle region of the flexible substrate, penetrating the flexible substrate, and the other end of the first anode leading-out wire extends along the length direction of the flexible substrate to be electrically connected with the first anode input pad;
each anode pad in the second group of anode pads is electrically connected with the second anode wire, one end of the second anode wire close to the anode input pad is electrically connected with one end of the second anode leading-out wire through a through hole penetrating the flexible substrate, and the other end of the second anode leading-out wire extends along the length direction of the flexible substrate to be electrically connected with the second anode input pad.

In a possible implementation, the first anode input pad, the second anode input pad, and the cathode input pad are sequentially arranged along a width direction of the flexible substrate.

In a possible implementation, widths of the flexible substrate at positions of the first anode input pad, the second anode input pad and the cathode input pad are greater than widths of the flexible substrate at remaining positions.

In a possible implementation, a first anode pad at the top of the plurality of anode pads arranged along the length direction of the flexible substrate is electrically connected with one end of the anode wire, and a last cathode pad at the end of the plurality of cathode pads arranged along the length direction of the flexible substrate is electrically connected with one end of the cathode wire;
the first metal layer further includes a plurality of serial connection wires, a previous cathode pad and a next anode pad along the length direction of the flexible substrate are electrically connected through the serial connection wire.

In a possible implementation, the other end of the anode wire electrically connected with the first anode pad, at a middle position of a first piezoelectric actuator at the top of the plurality of piezoelectric actuators, is electrically connected with one end of the anode leading-out wire through a through hole penetrating the flexible substrate, and the other end of the anode leading-out wire extends along the length direction of the flexible substrate to be electrically connected with the anode input pad;
the other end of the cathode wire electrically connected with the last cathode pad is electrically connected with one end of the cathode leading-out wire through a through hole penetrating the flexible substrate, and the other end of the cathode leading-out wire extends along the length direction of the flexible substrate to be electrically connected with the cathode input pad.

In a possible implementation, a shape of the piezoelectric actuator includes a rectangle or a circle.

In a possible implementation, a structure of the piezoelectric actuator is a piezoelectric film or a piezoelectric ceramic block body.

Correspondingly, a haptic feedback device according to embodiments of the present disclosure includes the haptic feedback assembly according to embodiments of the present disclosure.

In a possible implementation, the haptic feedback device further includes a cover plate, where a side of the piezoelectric actuator away from the flexible circuit board is attached to a peripheral region of the cover plate.

In a possible implementation, the haptic feedback device further includes a display module, where the display module and the haptic feedback assembly are on the same side of the cover plate, and the touch feedback assembly is disposed on the cover plate at at least a side of the display module.

In a possible implementation, the display module is provided with a pair of long sides oppositely arranged and a pair of short sides connected with the pair of long sides, the haptic feedback assembly is disposed between each long side and an adjacent edge of the cover plate, and an extending direction of a long side of the haptic feedback assembly is the same as an extending direction of a long side of the display module.

### Brief Description of Figures

FIG. 1 is a schematic view of a welding structure of a flexible circuit board and a piezoelectric actuator in a haptic feedback assembly according to embodiments of the present disclosure;
FIG. 2 is a schematic plan view of the piezoelectric actuator in FIG. 1;
FIG. 3A is a schematic plan view of a front surface and a back surface of the flexible circuit board in FIG. 1 without the piezoelectric actuator;
FIG. 3B is a cross-sectional view of a right end in FIG. 3A;
FIG. 3C is an enlarged plan view of the flexible circuit board below two piezoelectric actuators in FIG. 3A;
FIG. 3D is an enlarged plan view of the right end in FIG. 3A;
FIG. 4A is another schematic plan view of a front surface and a back surface of the flexible circuit board according to embodiments of the present disclosure;
FIG. 4B is a schematic plan view of the back surface of the flexible circuit board shown in FIG. 4A;
FIG. 4C is an enlarged plan view of a right end in FIG. 4A;
FIG. 4D is an enlarged plan view of a middle region in FIG. 4A;
FIG. 5A is another schematic plan view of a front surface and a back surface of the flexible circuit board according to embodiments of the present disclosure;
FIG. 5B is an enlarged plan view of a left end in FIG. 5A;
FIG. 6 is another schematic plan view of a front surface and a back surface of the flexible circuit board according to embodiments of the present disclosure;
FIG. 7A is another schematic plan view of a front surface and a back surface of the flexible circuit board according to embodiments of the present disclosure;
FIG. 7B is an enlarged plan view of a left end in FIG. 7A;
FIG. 7C is an enlarged plan view of a right end in FIG. 7A;
FIG. 8 is a sectional schematic diagram in which an anode wire on a first surface of the flexible substrate 11 in FIG. 3A is electrically connected with an anode leading-out wire on a second surface of the flexible substrate through a through hole penetrating the flexible substrate;
FIG. 9 is a schematic structural diagram of a haptic feedback device according to embodiments of the present disclosure;
FIG. 10 is a side view of FIG. 9 taken along a direction AA'.

### Detailed Description

For making objectives, technical solutions and advantages of embodiments of the present disclosure clearer, technical solutions of embodiments of the present disclosure will be clearly and completely described below in conjunction with accompanying drawings in embodiments of the present disclosure. Apparently, embodiments described are some rather than all of embodiments of the present disclosure. Embodiments in the present disclosure and features of embodiments may be combined with each other without conflict. Based on embodiments of the present disclosure, all other embodiments obtained by those of ordinary skill in the art without making creative efforts fall within the scope of protection of the present disclosure.

Unless otherwise defined, technical or scientific terms used in the present disclosure should have ordinary meanings as understood by those of ordinary skill in the art to which the present disclosure belongs. The word "including" or "comprising", etc. indicates that elements or objects before the word include elements or objects after the word and their equivalents, without excluding other elements or objects. The word "connection" or "link", etc. is not limited to physical or mechanical connections, but may include electrical connections, whether direct or indirect. "Inner", "outer", "upper", "lower", etc. are only used to indicate a relative positional relationship, and when an absolute position of a described object changes, the relative positional relationship may also change accordingly.

It should be noted that a size and a shape of each figure in the drawings do not reflect a true scale, but only for illustrating the present disclosure. Throughout the drawings, identical or similar reference numerals denote identical or similar elements or elements having identical or similar functions.

Multi-mode fusion of vision, hearing and touch has great significance and value for enhancing safety and effectiveness of operation and enriching user experience. At present, visual and auditory presentation technology has been relatively mature and rich, while haptic feedback is not rich and realistic enough. At present, mobile phones, wearable devices and other fields mainly produce vibration feedback through low-frequency vibration of ERM and LRA, with relatively simple and single effects, far from meeting expectations of the user. By using a piezoelectric transducer, auditory reminder can be generated through an action of a sound excitation signal during human-computer interaction; a vibration haptic feedback effect is generated by adopting an action of a low-frequency vibration signal; an excitation signal of a ultrasonic wave band generates a squeeze-film effect to change a surface friction coefficient, and a virtual surface haptic feedback effect similar to a texture, a stutter and the like is generated through waveform modulation.

At present, a surface haptic display structure generally has piezoelectric actuators disposed in a peripheral region of a cover plate. Piezoelectric actuators are generally connected with an external driving circuit through wires on the cover plate. The piezoelectric actuator is excited by the external driving circuit to vibrate and drive the cover plate to resonate to realize haptic feedback. Since the number of piezoelectric actuators is generally large, the number of wires connected by the conventional wire connection method on the cover plate is relatively large. Moreover, in order to meet the requirement of the maximum current, a wire with a thicker diameter is required to be selected. Requirements of display assembly generally do not have too much space to place so many wires. At the same time, because the piezoelectric actuator itself may drive the vibration, too many wire connections may produce unpredictable noise along with the vibration, affecting the haptic experience of the product.

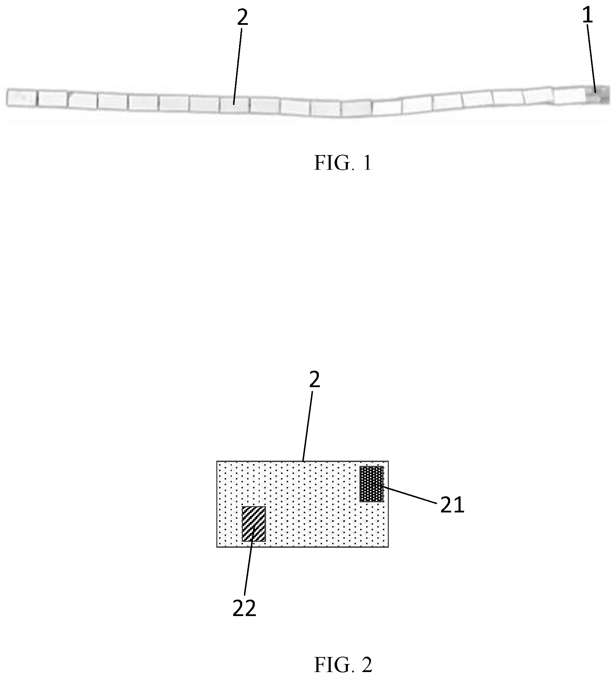

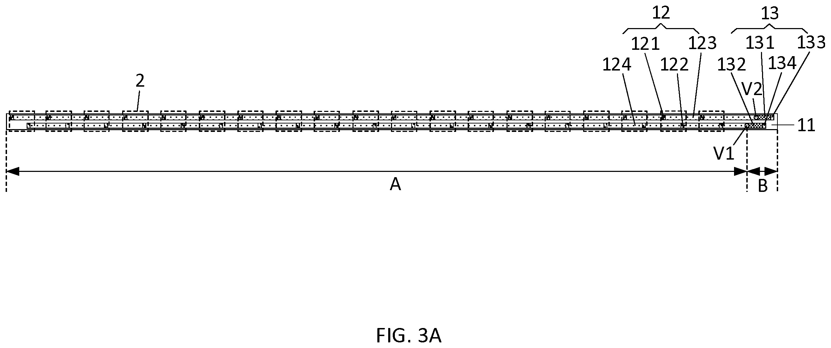

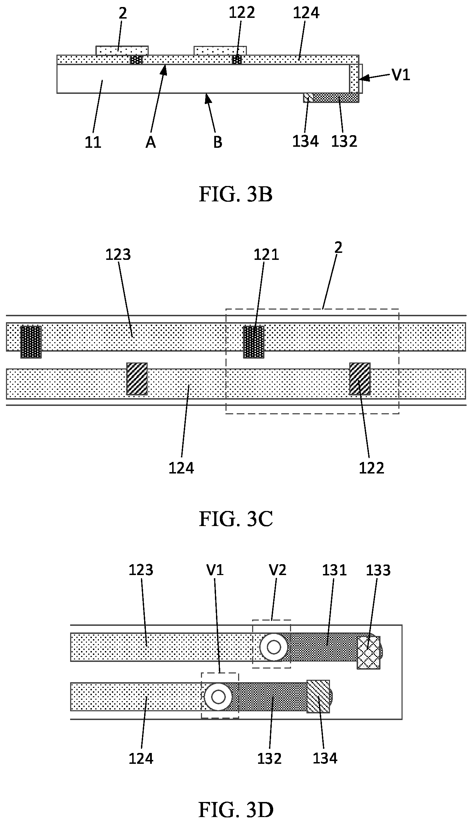

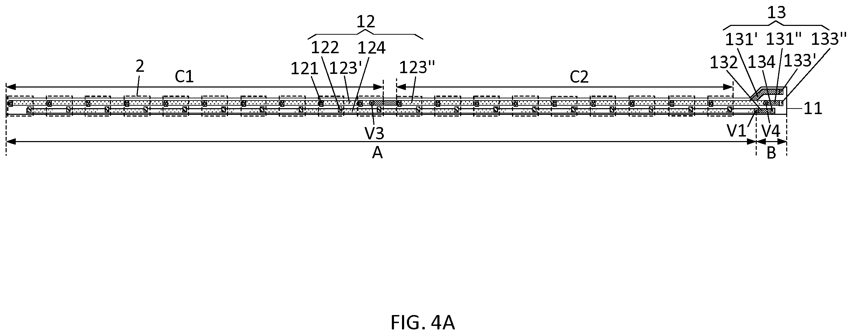

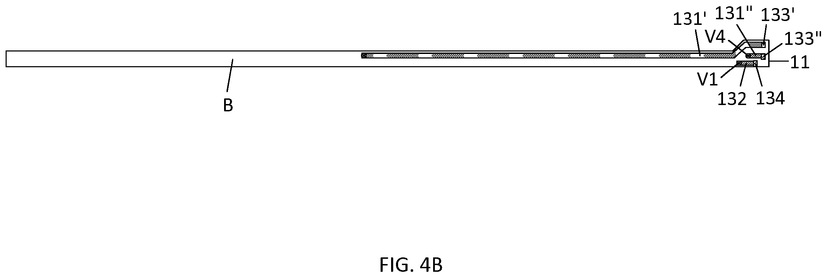

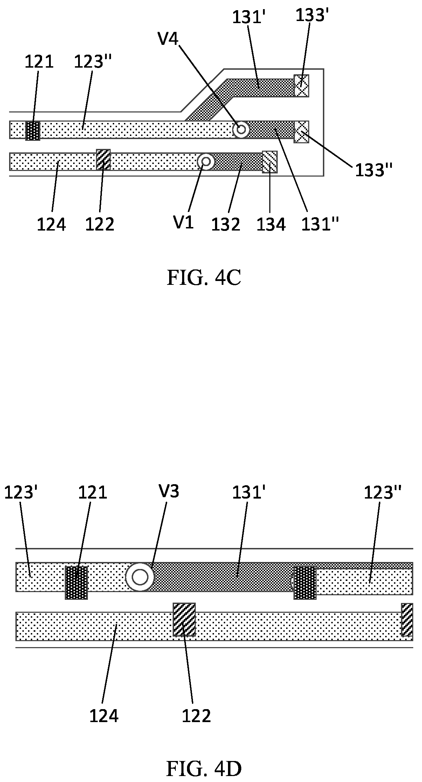

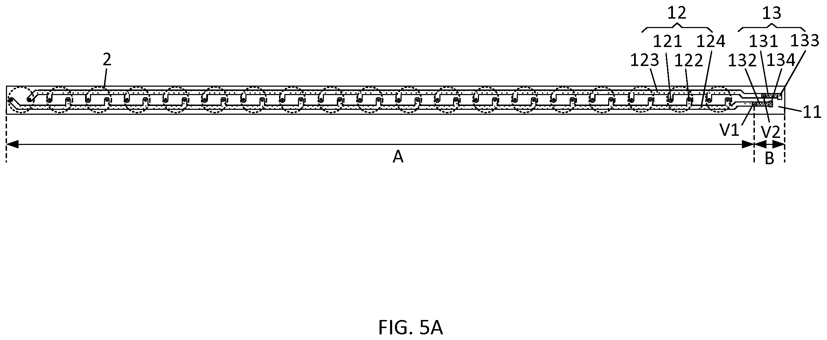

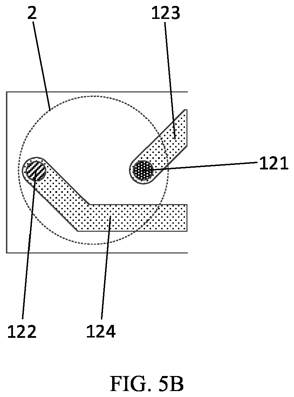

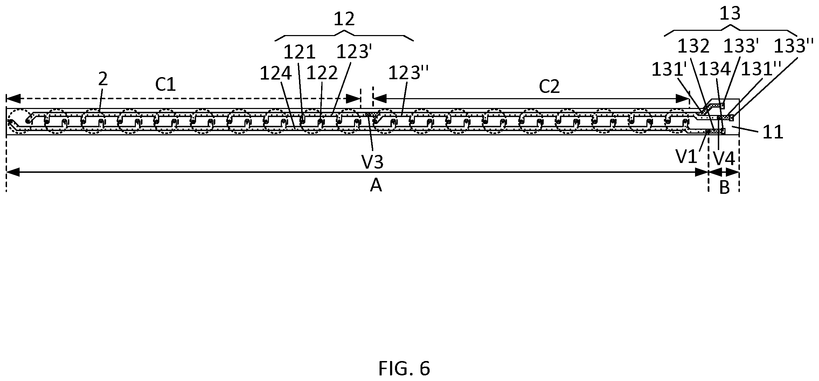

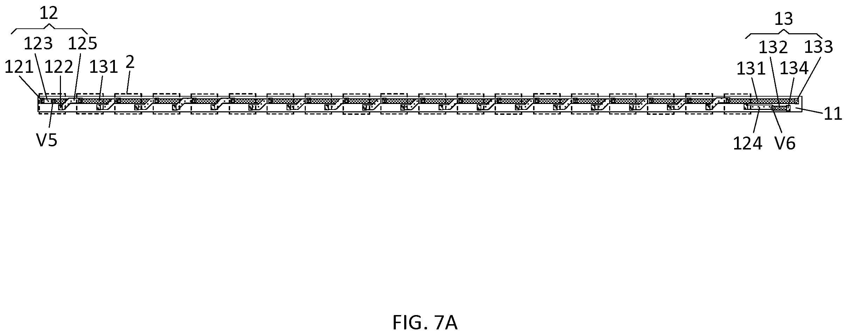

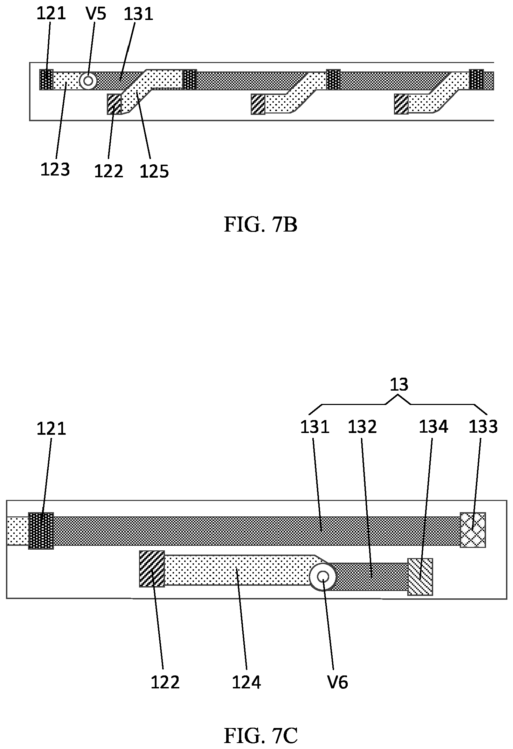

In order to solve problems that a bezel of an existing surface haptic display structure does not have a large amount of space for placing connection wires of piezoelectric actuators, and the connection wires of the piezoelectric actuators can generate noise along with vibration, embodiments of the present disclosure provide a haptic feedback assembly, as shown in FIGS. 1, 2, 3A, 3B, 3C, 3D, 4A, 4B, 4C, 4D, 5A, 5B, 6, 7A, 7B, and 7C. FIG. 1 is a schematic view of a welding structure of a flexible circuit board and a piezoelectric actuator in a haptic feedback assembly according to embodiments of the present disclosure. FIG. 2 is a schematic plan view of the piezoelectric actuator in FIG. 1. FIG. 3A is a schematic plan view of a front surface and a back surface of the flexible circuit board in FIG. 1 without the piezoelectric actuator. FIG. 3B is a cross-sectional view of a right end in FIG. 3A. FIG. 3C is an enlarged plan view of the flexible circuit board below two piezoelectric actuators in FIG. 3A. FIG. 3D is an enlarged plan view of the right end in FIG. 3A. FIG. 4A is another schematic plan view of a front surface and a back surface of the flexible circuit board according to embodiments of the present disclosure. FIG. 4B is a schematic plan view of the back surface of the flexible circuit board shown in FIG. 4A. FIG. 4C is an enlarged plan view of a right end in FIG. 4A. FIG. 4D is an enlarged plan view of a middle region in FIG. 4A. FIG. 5A is another schematic plan view of a front surface and a back surface of the flexible circuit board according to embodiments of the present disclosure. FIG. 5B is an enlarged plan view of a left end in FIG. 5A. FIG. 6 is another schematic plan view of a front surface and a back surface of the flexible circuit board according to embodiments of the present disclosure. FIG. 7A is another schematic plan view of a front surface and a back surface of the flexible circuit board according to embodiments of the present disclosure. FIG. 7B is an enlarged plan view of a left end in FIG. 7A. FIG. 7C is an enlarged plan view of a right end in FIG. 7A. The haptic feedback assembly includes followings.

A flexible circuit board 1 (FPC) includes a flexible substrate 11, a first metal layer 12 on a side of a first surface A of the flexible substrate 11, and a second metal layer 13 on a side of a second surface B of the flexible substrate 11. The first surface A and the second surface B are oppositely arranged along a thickness direction of the flexible substrate 11.

A plurality of piezoelectric actuators 2 are disposed on a side of the first metal layer 12 away from the flexible substrate 11. The piezoelectric actuators 2 are electrically connected with the first metal layer 12, the first metal layer 12 is electrically connected with the second metal layer 13 through a through hole penetrating the flexible substrate 11, the second metal layer 13 is electrically connected with an external driving circuit (PCB). The piezoelectric actuators 2 are configured to generate haptic feedback in response to a driving signal input by the external driving circuit (PCB).

According to the haptic feedback assembly according to embodiments of the present disclosure, the piezoelectric actuators are connected with the external PCB by means of the FPC. Because wires can be arranged on both sides of the FPC, when the haptic feedback assembly of the present disclosure is integrated with a display or touch substrate, space of a bezel region of the substrate occupied by wires connected with the piezoelectric actuators can be reduced, to realize a narrow bezel. And by properly arranging the way that the piezoelectric actuators are connected with the PCB through the wires, it is also possible to reduce noise generated by the wires as the piezoelectric actuators vibrate.

It should be noted that, for illustrative purposes, in FIGS. 3A, 4A, 5A, 6, and 7A, the first metal layer 12 on the first surface A and the second metal layer 13 on the second surface B of the flexible substrate 11 are Illustrated by way of example on the same plane. Of course, the actual structure is that the first metal layer 12 and the second metal layer 13 are located on both sides of the flexible substrate 11 as shown in FIG. 3B.

It should be noted that, in FIGS. 3A, FIG. 4A, FIG. 5A, FIG. 6 and FIG. 7A, welding positions (i.e., areas occupied by respective piezoelectric actuators 2 on the flexible circuit board 1) corresponding to respective piezoelectric actuators 2 are respectively divided by dashed line frames.

In some embodiments, in the haptic feedback assembly according to embodiments of the present disclosure, a material of the flexible substrate includes but is not limited to polyimide (PI), polymethyl methacrylate (PMMA), polycarbonate (PC), Polyethylene terephthalate (PET), PC/PMMA composite material, organic-inorganic composite material.

In some embodiments, in the haptic feedback assembly according to embodiments of the present disclosure, as shown in FIG. 2, a side of the piezoelectric actuator 2 facing the flexible circuit board 1 is provided with an anode leading-out structure 21 and a cathode leading-out structure 22.

As shown in FIGS. 3A, 4A, 5A, 6, and 7A, the first metal layer 12 includes a plurality of anode pads 121, a plurality of cathode pads 122, an anode wire 123, and a cathode wire 124. The anode leading-out structure 21 in FIG. 2 is electrically connected with the anode pad 121 in FIGS. 3A, 4A, 5A, 6, and 7A. The cathode leading-out structure 22 in FIG. 2 is electrically connected with the cathode pad 122 in FIGS. 3A, 4A, 5A, 6, and 7A. The anode pad 121 is electrically connected with the anode wire 123, and the cathode pad 122 is electrically connected with the cathode wire 124.

In some embodiments, in the haptic feedback assembly according to embodiments of the present disclosure, as shown in FIGS. 3A, 4A, 5A, 6, and 7A, the second metal layer 13 includes an anode leading-out wire 131, a cathode leading-out wire 132, an anode input pad 133, and a cathode input pad 134. The anode wire 123 is electrically connected with the anode leading-out wire 131, and the cathode wire 124 is electrically connected with the cathode leading-out wire 132. The anode leading-out wire 131 is electrically connected with the anode input pad 133, the anode input pad 133 is electrically connected with the external driving circuit (PCB). The cathode leading-out wire 132 is electrically connected with the cathode input pad 134, and the cathode input pad 134 is electrically connected with the external driver circuit (PCB). In this way, when the haptic feedback assembly according to embodiments of the present disclosure is integrated with a cover plate of a display, because a side of the piezoelectric actuator 2 away from the flexible circuit board 1 is attached to the cover plate, the anode input pad 133 and the cathode input pad 134 are thus arranged on the second surface B of the flexible circuit board 1 away from the piezoelectric actuator 2, to facilitate electrical connection of the anode input pad 133 and the cathode input pad 134 to the external driving circuit (PCB). Thus, the anode leading-out structure 21 and the cathode leading-out structure 22 of the piezoelectric actuator 2 are connected with the PCB through the pads and the wires on the first surface A of the FPC and the leading-out wires and the input pads on the surface B of the FPC respectively. The PCB inputs a driving signal to the piezoelectric actuator 2 through the input pads, the leading-out wires, the wires and the pads. The piezoelectric actuator 2 vibrates under excitation of the driving signal to generate haptic feedback.

In some embodiments, in the haptic feedback assembly according to embodiments of the present disclosure, as shown in FIGS. 3A, 4A, 5A, 6, and 7A, the plurality of anode pads 121 are sequentially arranged on the first surface A of the flexible substrate 11 along a length direction of the flexible substrate 11, and the plurality of cathode pads 122 are sequentially arranged on the first surface A of the flexible substrate 11 along the length direction of the flexible substrate 11. In this way, when the piezoelectric actuator 2 shown in FIG. 2 is welded to the anode pad 121 and the cathode pad 122, the piezoelectric actuators 2 are sequentially arranged on the first surface A of the flexible substrate 11 along the length direction of the flexible substrate 11 (for example, as shown in FIG. 1), that is, the haptic feedback assembly according to embodiments of the present disclosure is an elongated bar, and the piezoelectric actuators 2 are arranged along a row, which can reduce a width of the haptic feedback assembly. For example, when the haptic feedback assembly according to embodiments of the present disclosure is integrated with a display, the haptic feedback assembly may be attached to a peripheral region (e.g., a long side) of the cover plate. Because wires of the piezoelectric actuators 2 are arranged on both side of the FPC, a width of the peripheral region of the cover plate can be reduced, to realize a narrow bezel.

In some embodiments, in the haptic feedback assembly according to embodiments of the present disclosure, as shown in FIGS. 3A, 4A, and 7A, the plurality of anode pads 121 and the plurality of cathode pads 122 may be located in different rows and arranged in parallel, to reduce the width of the flexible substrate 11. When the haptic feedback device is integrated with a display or touch cover plate, a narrow bezel can be realized. As shown in FIGS. 5A and 6, the plurality of anode pads 121 and the plurality of cathode pads 122 may be located in the same row. No matter whether the anode pads 121 and the cathode pads 122 are located in the same row or in different rows, as long as the anode pads 121 are electrically connected with the anode input pad 133 on the second surface B of the flexible substrate 11 through the anode wire 123, and the cathode pads 122 are electrically connected with the cathode input pad 134 on the second surface B of the flexible substrate 11 through the cathode wire 124.

In some embodiments, in the haptic feedback assembly according to embodiments the present disclosure, as shown in FIGS. 3A, FIG. 4A, FIG. 5A, FIG. 6, and FIG. 7A, the anode pads 121 and the cathode pads 122 are alternately arranged along the length direction of the flexible substrate 11, and each of the piezoelectric actuators 2 covers one anode pad 121 and one cathode pad 122 adjacent to each other. Thus, the piezoelectric actuator 2 shown in FIG. 2 is correspondingly welded to the anode pad 121 and the cathode pad 122 to form the haptic feedback assembly shown in FIG. 1.

In some embodiments, in the haptic feedback assembly according to embodiments the present disclosure, as shown in FIGS. 1, 3A, 4A, 5A, 6, and 7A, the anode input pad 133 and the cathode input pad 134 may be located at the same end of the flexible substrate 11, but are not limited thereto.

In some embodiments, in the haptic feedback assembly according to embodiments of the present disclosure, as shown in FIGS. 3A, 4A, 5A, and 6, all of the cathode pads 122 are electrically connected with the same cathode wire 124, one end of the cathode wire 124 close to the cathode input pad 134 is electrically connected with one end of the cathode leading-out wire 132 through a through hole V1 penetrating the flexible substrate 11, and the other end of the cathode leading-out wire 132 extends along the length direction of the flexible substrate 11 to be electrically connected with the cathode input pad 134. In this way, all the piezoelectric actuators 2 share the same cathode, and by setting the anode connection mode of each piezoelectric actuator 2, driving forms such as integral driving, partition driving and the like can be realized.

In some embodiments, in the haptic feedback assembly according to embodiments of the present disclosure, as shown in FIGS. 3A and 5A, all of the anode pads 121 are electrically connected with the same anode wire 123, one end of the anode wire 123 close to the anode input pad 133 is electrically connected with one end of the anode leading-out wire 131 through a through hole V2 penetrating the flexible substrate 11, and the other end of the anode leading-out wire 131 extends along the length direction of the flexible substrate 11 to be electrically connected with the anode input pad 133. In this way, anodes of all the piezoelectric actuators 2 are connected in parallel, cathodes of all the piezoelectric actuators 2 are connected in parallel. After all the piezoelectric actuators 2 are connected in parallel, the piezoelectric actuators 2 are connected with the external driver circuit (PCB) through through holes penetrating the flexible substrate 11, the anode and cathode leading-out wires on the second surface of the flexible substrate 11, and the rightmost anode and cathode input pads 133 and 134. Driving for the piezoelectric actuators 2 in FIGS. 3A and 5A is in the form of integral driving. For example, a ground voltage signal is applied to the cathode input pad 134 through the PCB. The ground voltage signal is transmitted to a cathode of each of the piezoelectric actuators 2 through the cathode input pad 134, the cathode leading-out wire 132, the cathode wire 124, and the cathode pad 122. An AC voltage signal is applied to the anode input pad 133. The AC voltage signal is transmitted to an anode of each of the piezoelectric actuators 2 through the anode input pad 133, the anode leading-out wire 131, the anode wire 123, and the anode pad 121. In this way, an alternating electric field can be formed between the anode of the piezoelectric actuator 2 and the cathode of the piezoelectric actuator 2, and under an action of the alternating electric field, the piezoelectric actuator 2 generates vibration to realize haptic feedback.

In some embodiments, in the haptic feedback assembly according to embodiments of the present disclosure, as shown in FIGS. 3A and 5A, when integrating the haptic feedback assembly with the display, a distance between adjacent piezoelectric actuators 2 is determined by a position of the piezoelectric actuators 2 on the display. To meet the requirement of large current, widths of the anode wire 123 and the cathode wire 124 on the first surface A of the flexible circuit board 1, and widths of the anode leading-out wire 131 and the cathode leading-out wire 132 on the second surface B of the flexible circuit board 1 are greater than or equal to 2.54 mm, and a wire spacing between the anode wire 123 and the cathode wire 124 and a wire spacing between the anode leading-out wire 131 and the cathode leading-out wire 132 are greater than or equal to 0.5 mm.

In some embodiments, in the haptic feedback assembly according to embodiments of the present disclosure, as shown in FIGS. 3A and 5A, when integrating the haptic feedback assembly with the display, a narrow bezel and subsequent assembly requirements are taken into consideration. The entire flexible circuit board 1 may have a width of 1 cm, a thickness of 1 mm, and a total length of 42 cm. For example, in embodiments of that present disclosure, nineteen piezoelectric actuators 2 are connected together in parallel. Of course, the total length of the flexible circuit board 1 and the number of the piezoelectric actuators 2 may be determined by the size of the integrated display.

In some embodiments, in the haptic feedback assembly according to embodiments of the present disclosure, as shown in FIGS. 4A and 6, the plurality of anode pads 121 are divided into at least two groups of anode pads along the length direction of the flexible substrate 11 (two groups of C1 and C2 are taken as examples in the present disclosure). Each group of anode pads 121 is electrically connected with the same anode wire 123. Different groups of anode pads 121 are electrically connected with different cathode wires 124. Thus, anodes of the piezoelectric actuators 2 of the group C1 are connected in parallel, anodes of the piezoelectric actuators 2 of the group C2 are connected in parallel. Cathodes of all the piezoelectric actuators 2 are connected in parallel. The piezoelectric actuators 2 are driven in the form of partition driving in FIGS. 4A and 6. That is, the piezoelectric actuators 2 of the group C1 are driven together, the piezoelectric actuators 2 of the group C2 are driven together. It is possible to select whether to drive the C1 group or the C2 group according to the vibration requirement, so that the power consumption can be reduced.

In some embodiments, in the haptic feedback assembly according to embodiments of the present disclosure, as shown in FIGS. 4A and 6, the plurality of anode pads 121 are divided into a first group C1 of anode pads 121 and a second group C2 of anode pads 121 along the length direction of the flexible substrate 11. The anode wire 123 includes a first anode wire 123' and a second anode wire 123". The anode leading-out wire 131 includes a first anode leading-out wire 131' and a second anode leading-out wire 131". The anode input pad 133 includes a first anode input pad 133' and a second anode input pad 133".

Each anode pad 121 in the first group C1 of anode pads 121 is electrically connected with the first anode wire 123'. The first anode wire 123' is electrically connected with one end of the first anode leading-out wire 131' through a through hole V3, in a middle region of the flexible substrate 11, penetrating the flexible substrate 11, and the other end of the first anode leading-out wire 131' extends along the length direction of the flexible substrate 11 to be electrically connected with the first anode input pad 133'.

Each anode pad 121 in the second group C2 of anode pads 121 is electrically connected with the second anode wire 123". One end of the second anode wire 123" close to the anode input pad (133') is electrically connected with one end of the second anode leading-out wire 131" through a through hole V4 penetrating the flexible substrate 11, and the other end of the second anode leading-out wire 131" extends along the length direction of the flexible substrate 11 to be electrically connected with the second anode input pad 133". The piezoelectric actuators 2 to which the anode pads 121 of the first group C1 are electrically connected are the piezoelectric actuators 2 of the first group C1. The piezoelectric actuators 2 to which the anode pads 121 of the second group C2 are electrically connected are the second group C2 of piezoelectric actuators 2. The first group C1 of piezoelectric actuators 2 and the second group C2 of piezoelectric actuators 2 both apply a ground voltage signal to the cathode input pad 134 through the PCB. The ground voltage signal is transmitted to the cathode of each of the piezoelectric actuator 2 in the first group C1 and the second group C2 through the cathode input pad 134, the cathode leading-out wire 132, the cathode wire 124, and the cathode pad 122. An alternating voltage signal is applied through the PCB to the first anode input pad 133' corresponding to the first group C1 of piezoelectric actuators 2. The AC voltage signal is transmitted to the anode of each of the piezoelectric actuators 2 in the first group C1 through the first anode input pad 133', the first anode leading-out wire 131', the first anode wire 123', and the anode pad 121. An alternating voltage signal is applied through the PCB to the second anode input pad 133 corresponding to the second group C1 of piezoelectric actuators 2. The AC voltage signal is transmitted to the anode of each of the piezoelectric actuators 2 in the second group C2 through the second anode input pad 133", the second anode leading-out wire 131", the second anode wire 123", and the anode pad 121. In this way, the first group C1 of piezoelectric actuators 2 and the second group C2 of piezoelectric actuators 2 can be driven in different regions using different driving signals.

In some embodiments, in the haptic feedback assembly according to embodiments of the present disclosure, as shown in FIGS. 4A and 6, the first anode input pad 133', the second anode input pad 133", and the cathode input pad 134 may be sequentially arranged along a width direction of the flexible substrate 11. Of course, it is not limited to this.

In some embodiments, in the haptic feedback assembly according to embodiments of the present disclosure, as shown in FIGS. 4A and 6, widths of the flexible substrate 11 at positions of the first anode input pad 133', the second anode input pad 133" and the cathode input pad 134 are greater than widths of the flexible substrate 11 at remaining positions.

In some embodiments, in the haptic feedback assembly according to embodiments of the present disclosure, as shown in FIGS. 4A and 6, a width of the flexible circuit board 1 corresponding to a region where the piezoelectric actuator 2 is located may be 1 cm, widths of the flexible circuit board 1 where the first anode input pad 133', the second anode input pad 133" and the cathode input pad 134 are located are 1.5 cm. A thickness of the flexible circuit board 1 may be 1 mm, and a total length of the flexible circuit board 1 may be 42 cm. For example, in embodiments of that present disclosure, nineteen piezoelectric actuators 2 are connected together in parallel. Of course, the total length of the flexible circuit board 1 and the number of the piezoelectric actuators 2 may be determined by the size of the integrated display.

It should be noted that, the piezoelectric actuators 2 shown in FIGS. 4A and 6 are divided into a first group C1 (i.e., the left half) and a second group C2 (i.e., the right half). Of course, it is not limited to this. For example, the piezoelectric actuators 2 can be divided into three or more groups from left to right. Different groups are driven by different driving signals, which is beneficial to fine control of vibration effect. However, the more the number of groups of piezoelectric actuators 2 is, the wider the width of the corresponding flexible circuit board will be. When being integrated with the display, more bezel space is occupied, which is not conducive to achieving a narrow bezel.

In some embodiments, in the haptic feedback assembly according to embodiments of the present disclosure, as shown in FIG. 7A, the first anode pad 121 (leftmost end) at the top of the plurality of anode pads arranged along the length direction of the flexible substrate 11 is electrically connected with one end of the anode wire 123, and the last cathode pad 122 (rightmost end) at the end of the plurality of cathode pads arranged along the length direction of the flexible substrate 11 is electrically connected with one end of the cathode wire 124.

The first metal layer 12 further includes a plurality of serial connection wires 125. A previous cathode pad 122 and a next anode pad 121 along the length direction of the flexible substrate 11 are electrically connected through the serial connection wire 125. For example, the leftmost anode pad 121 is directly connected with the rightmost anode input pad 133 through the anode wire 123. The cathode pad 122 corresponding to the first piezoelectric actuator 2 at the top of the plurality of piezoelectric actuators from the left is connected with the anode pad 121 corresponding to the second piezoelectric actuator 2 from the left. The cathode pad 122 corresponding to the second piezoelectric actuator 2 from the left is connected with the anode pad 121 corresponding to the third piezoelectric actuator 2 from the left, and so on. The cathode pad of the rightmost piezoelectric actuator 2 is directly connected with the rightmost cathode input pad 134 through the cathode wire 124. In this way, the piezoelectric actuators 2 in the structure shown in FIG. 7A are connected in series, and the piezoelectric actuators 2 can be integrally driven. Compared with the integral parallel driving, the integral series driving can reduce the power consumption.

In some embodiments, in the haptic feedback assembly according to embodiments of the present disclosure, as shown in FIG. 7A, the other end of the anode wire 123 electrically connected with the first anode pad 121, at a middle position of the first piezoelectric actuator 2, is electrically connected with one end of the anode leading-out wire 131 through a through hole penetrating the flexible substrate 11, and the other end of the node leading-out wire 131 extends along the length direction of the flexible substrate 11 to be electrically connected with the anode input pad 133.

The other end of the cathode wire 124 electrically connected with the last cathode pad 122 is electrically connected with one end of the cathode leading-out wire 132 through a through hole penetrating the flexible substrate 11, and the other end of the cathode leading-out wire 132 extends along the length direction of the flexible substrate 11 to be electrically connected with the cathode input pad 134. In this way, the anodes and the cathodes of all the piezoelectric actuators 2 are connected in series, and the piezoelectric actuators 2 are driven in an integral manner in FIG. 7A. For example, a ground voltage signal is applied to the cathode input pad 134, and an AC voltage signal is applied to the anode input pad 133 through the PCB. Thus, an alternating electric field can be formed between the anode of the piezoelectric actuator 2 and the cathode of the piezoelectric actuator 2. Under the action of the alternating electric field, the piezoelectric actuator 2 generates vibration to realize haptic feedback.

In some embodiments, in the haptic feedback assembly according to embodiments of the present disclosure, as shown in FIG. 7A, in order to meet the requirement of large current, widths of the anode wire 123 and the cathode wire 124 on the first surface A of the flexible circuit board 1, and widths of the anode leading-out wire 131 and the cathode leading-out wire 132 on the second surface B of the flexible circuit board 1 are greater than or equal to 2.54 mm, and a wire spacing between the anode wire 123 and the cathode wire 124 and a wire spacing between the anode leading-out wire 131 and the cathode leading-out wire 132 are greater than or equal to 0.5 mm. The entire flexible circuit board 1 may have a width of 1 cm, a thickness of 1 mm, and a total length of 42 cm.

In some embodiments, in the haptic feedback assembly according to embodiments of the present disclosure, as shown in FIGS. 3A, 4A and 7A, a shape of the piezoelectric actuator 2 may be a rectangle. The anode pad 121 and the cathode pad 122 may be located in different rows, without being limited thereto, as long as the anode wire 123 and the cathode wire 124 are not short-circuited.

In some embodiments, in the haptic feedback assembly according to embodiments of the present disclosure, as shown in FIGS.5A and 6, the shape of the piezoelectric actuator 2 may be a circle. The anode pad 121 and the cathode pad 122 may be located in the same row. Of course, the anode pad 121 and the cathode pad 122 can also be located in different rows as shown in FIG. 3A and FIG. 4A, as long as the anode wire 123 and the cathode wire 124 are not short-circuited.

In some embodiments, in the haptic feedback assembly according to embodiments the present disclosure, the shape of the piezoelectric actuator 2 shown in FIG. 7A may also be a circle.

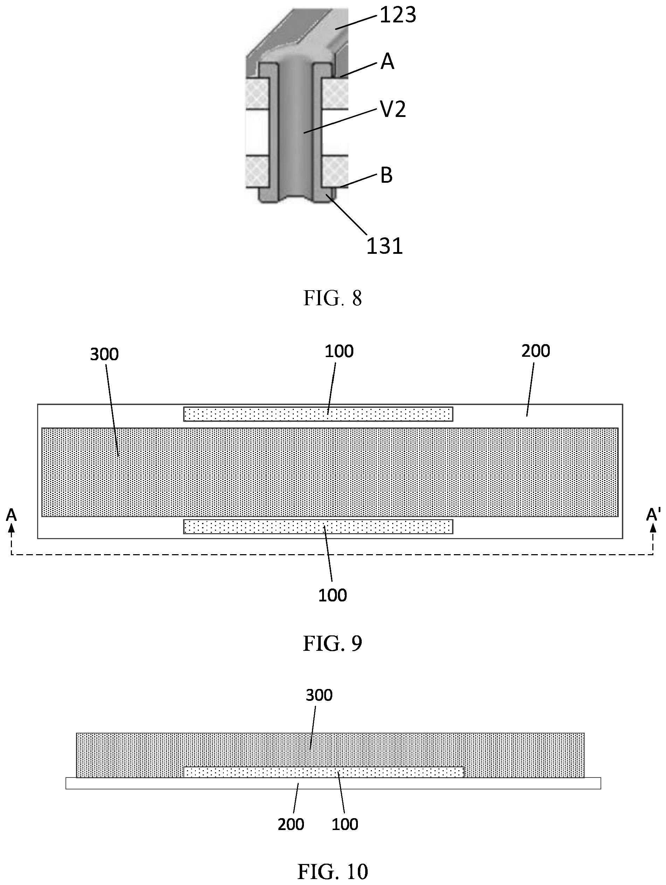

In some embodiments, in the haptic feedback assembly according to embodiments of the present disclosure, as shown in FIG. 8, FIG. 8 is a sectional schematic diagram in which an anode wire 123 on a first surface A of the flexible substrate 11 in FIG. 3A is electrically connected with an anode leading-out wire 131 on a second surface B of the flexible substrate 11 through a through hole V2 penetrating the flexible substrate 11. Other sectional schematic diagrams of connection through through holes are the same as those in FIG. 8.

In some embodiments, in the haptic feedback assembly according to embodiments the present disclosure, a structure of the piezoelectric actuator is a piezoelectric film or a piezoelectric ceramic block body. By adopting the piezoelectric film or the piezoelectric ceramic block body a given piezoelectric actuator voltage can directly provide vibration excitation. The structure can generate ultrasonic vibration by using a resonance frequency of a part of a screen module, so that the haptic feedback assembly produces a haptic feedback effect and the haptic feedback can be adjusted by a squeeze film effect.

It should be noted that, the anode leading-out structure 21 and the cathode leading-out structure 22 of the piezoelectric actuator 2 shown in FIG. 2 are welded to positions of dashed line frames in FIGS. 3A, 4A, 5A, 6A and 7A by welding.

In some embodiments, the haptic feedback assembly according to embodiments of the present disclosure may be integrated into a product such as a notebook, a display, etc., and can be used as a display screen in many fields such as vehicle display, consumer electronics and so on, providing users with rich and vivid haptic experience.

Based on the same inventive concept, embodiments of the present disclosure further provide a haptic feedback device, as shown in FIGS.9 and 10. FIG. 9 is a schematic plan view of the haptic feedback device, and FIG. 10 is a side view of FIG. 9 taken along a direction AA'. The haptic feedback device includes the haptic feedback assembly 100 described above in accordance with embodiments of the present disclosure.

In some embodiments, the haptic feedback device according to embodiments of the present disclosure, as shown in FIGS. 9 and 10 further includes a cover plate 200. A side of the piezoelectric actuator 2 in the haptic feedback assembly 100 shown in FIGS. 1, 2, 3A, 4A, 5A, 6, or 7A according to embodiments of the present disclosure away from the flexible circuit board 1 is attached to a peripheral region of the cover plate 200. A height of the haptic feedback assembly 100 should not be too high, generally no more than 5 mm.

In some embodiments, in the haptic feedback device according to embodiments of the present disclosure, as shown in FIGS. 9 and 10, the cover plate 200 is a structure that is in direct contact with a haptic sense organ such as a finger, can be a cover plate on a surface of a notebook display module, a cover plate on a surface of a vehicle-mounted display module, a cover plate on a surface of a mobile terminal display module, or a cover plate on a surface of a display module in other application scenarios.

In some embodiments, in the haptic feedback device according to embodiments of the present disclosure, as shown in FIGS. 9 and 10, a display module 300 and the haptic feedback assembly 100 are disposed on the same side of the cover plate 200, and the display module 300 and the haptic feedback assembly 100 are disposed on a non-touch side of the cover plate 200. The haptic feedback assembly 100 is disposed on the cover plate 200 at at least a side of the display module 300. In this way, the PCB can generate a driving signal to transmit to the piezoelectric actuator 2 according to touch information of a touch object (such as a finger) on the cover plate 200. The piezoelectric actuator 2 vibrates the cover plate 200 in response to the driving signal, to form haptic feedback on a touch surface of the cover plate 200.

In some embodiments, in the haptic feedback device according to embodiments of the present disclosure, as shown in FIG. 9, the display module 300 is provided with a pair of long sides arranged oppositely and a pair of short sides connected with the pair of long sides. For a haptic feedback assembly 100 that only requires the long sides of the cover plate 200 to be excited to vibrate, the haptic feedback assembly 100 may be disposed on only a side of a pair of long sides of the cover plate 200. For a haptic feedback assembly 100 that only requires the short sides of the cover plate 200 to be excited to vibrate, the haptic feedback assembly 100 may be disposed only on a side of a pair of short sides of the cover plate 200, so that the number of the piezoelectric actuators 2 can be saved, the cost is reduced and the power consumption is reduced. In embodiments of the present disclosure, the haptic feedback assembly 100 is disposed between each long side and an adjacent edge of the cover plate 200, and an extending direction of a long side of the haptic feedback assembly 100 is the same as an extending direction of a long side of the display module 300, so that the haptic feedback assembly 100 is disposed between each long side and an adjacent edge of the cover plate 200, to achieve uniformity of the haptic feedback. The extending direction of the long side of the haptic feedback assembly 100 is the same as the extending direction of the long side of the display module 300, achieve to narrow bezels.

Of course, in some embodiments, in the haptic feedback device according to embodiments of the present disclosure, as shown in FIG. 9, for a haptic feedback assembly that requires all sides of the cover plate 200 to be excited to vibrate, the haptic feedback assembly 100 can be disposed around the cover plate 200, and a position of the haptic feedback assembly 100 can be designed according to actual requirements.

In some embodiments, the display module may be a liquid crystal display module or a self-luminous display module, which is not limited in the present disclosure. The liquid crystal display module includes a liquid crystal display panel and a backlight source, and a light-emitting device is arranged in the self-luminous display module. The light-emitting device may be, for example, an Organic Light-Emitting Diode (OLED), a Quantum Dot Light- Emitting Diode (QLED), a Mini Light- Emitting Diode (Mini LED) or a Micro Light- Emitting Diode (Micro LED), etc.

In some embodiments, the display module may further include a touch function layer.

Since the principle of the haptic feedback device solving the problem is similar to that of the haptic feedback assembly, implementations of the haptic feedback device can be referred to implementations of the haptic feedback assembly, and the repetition is not repeated. The haptic feedback device may be a vehicle-mounted display device.

Optionally, the haptic feedback device may be a mobile phone, a tablet computer, a smart wearable device (such as a smart watch), a vehicle display screen, or the like.

In practice, the haptic feedback device according to embodiments of the present disclosure may also include other functional structures known to those skilled in the art, which are not described in detail here.

Embodiments of the disclosure provide a haptic feedback assembly and a haptic feedback device. The haptic feedback assembly connects the piezoelectric actuator to an external PCB in an FPC mode. Because wires can be arranged on both sides of the FPC, when the haptic feedback assembly of the present disclosure is integrated with the display or touch substrate, the space of the bezel region of the substrate occupied by the wires connected with the piezoelectric actuators can be reduced, so that a narrow bezel can be realized. By properly arranging the way that the piezoelectric actuator is connected with the PCB through the wires, it is also possible to reduce the noise generated by the wires as the piezoelectric actuator vibrates.

Although embodiments of the present disclosure have been described, those of skill in the art may otherwise make various modifications and variations to these embodiments once they are aware of the basic inventive concept. Therefore, the claims intend to include embodiments as well as all these modifications and variations falling within the scope of the present disclosure.

Apparently, those skilled in the art can make various modifications and variations to embodiments of the present disclosure without departing from the spirit and scope of embodiments of the present disclosure. In this way, if the modifications and variations of embodiments of the present disclosure fall within the scope of the claims of the present disclosure and their equivalent technologies, the present disclosure is also intended to include these modifications and variations.

## Claims

1. A haptic feedback assembly, comprising:
a flexible circuit board, comprising a flexible substrate, a first metal layer on a side of a first surface of the flexible substrate, and a second metal layer on a side of a second surface of the flexible substrate; wherein the first surface and the second surface are oppositely arranged along a thickness direction of the flexible substrate; and
a plurality of piezoelectric actuators, on a side of the first metal layer away from the flexible substrate, wherein the piezoelectric actuators are electrically connected with the first metal layer, the first metal layer is electrically connected with the second metal layer through a through hole penetrating the flexible substrate, and the second metal layer is electrically connected with an external driving circuit; wherein the piezoelectric actuators are configured to generate haptic feedback in response to a driving signal input by the external driving circuit.

2. The haptic feedback assembly according to claim 1, wherein a side of the piezoelectric actuator facing the flexible circuit board is provided with an anode leading-out structure and a cathode leading-out structure;
the first metal layer comprises a plurality of anode pads, a plurality of cathode pads, an anode wire and a cathode wire, the anode leading-out structure is electrically connected with the anode pad, the cathode leading-out structure is electrically connected with the cathode pad, the anode pad is electrically connected with the anode wire, and the cathode pad is electrically connected with the cathode wire.

3. The haptic feedback assembly according to claim 2, wherein the second metal layer comprises an anode leading-out wire, a cathode leading-out wire, an anode input pad and a cathode input pad; wherein the anode wire is electrically connected with the anode leading-out wire, the cathode wire is electrically connected with the cathode leading-out wire, the anode leading-out wire is electrically connected with the anode input pad, the anode input pad is electrically connected with the external driving circuit, the cathode leading-out wire is electrically connected with the cathode input pad, and the cathode input pad is electrically connected with the external driving circuit.

4. The haptic feedback assembly according to claim 3, wherein the plurality of anode pads are sequentially arranged on the first surface of the flexible substrate along a length direction of the flexible substrate, and the plurality of cathode pads are sequentially arranged on the first surface of the flexible substrate along the length direction of the flexible substrate.

5. The haptic feedback assembly according to claim 4, wherein the plurality of anode pads and the plurality of cathode pads are located in different rows and arranged in parallel, or the plurality of anode pads and the plurality of cathode pads are located in the same row.

6. The haptic feedback assembly according to claim 5, wherein the anode pads and the cathode pads are alternately arranged along the length direction of the flexible substrate, and each of the piezoelectric actuators covers one of the anode pads and one of the cathode pads adjacent to each other, wherein the one of the anode pads and the one of the cathode pads are adjacent to each other.

7. The haptic feedback assembly according to claim 6, wherein the anode input pad and the cathode input pad are located at the same end of the flexible substrate.

8. The haptic feedback assembly according to claim 7, wherein all of the cathode pads are electrically connected with the same cathode wire, one end of the cathode wire close to the cathode input pad is electrically connected with one end of the cathode leading-out wire through a through hole penetrating the flexible substrate, and the other end of the cathode leading-out wire extends along the length direction of the flexible substrate to be electrically connected with the cathode input pad.

9. The haptic feedback assembly according to claim 8, wherein all of the anode pads are electrically connected with the same anode wire, one end of the anode wire close to the anode input pad is electrically connected with one end of the anode leading-out wire through a through hole penetrating the flexible substrate, and the other end of the anode leading-out wire extends along the length direction of the flexible substrate to be electrically connected with the anode input pad.

10. The haptic feedback assembly according to claim 8, wherein the plurality of anode pads are divided into at least two groups of anode pads along the length direction of the flexible substrate, each group of anode pads is electrically connected with the same anode wire, and different groups of anode pads are electrically connected with different cathode wires.

11. The haptic feedback assembly according to claim 10, wherein the plurality of anode pads are divided into a first group of anode pads and a second group of anode pads along the length direction of the flexible substrate, the anode wire comprises a first anode wire and a second anode wire, the anode leading-out wire comprises a first anode leading-out wire and a second anode leading-out wire, and the anode input pad comprises a first anode input pad and a second anode input pad;
each anode pad in the first group of anode pads is electrically connected with the first anode wire, the first anode wire is electrically connected with one end of the first anode leading-out wire through a through hole, in a middle region of the flexible substrate, penetrating the flexible substrate, and the other end of the first anode leading-out wire extends along the length direction of the flexible substrate to be electrically connected with the first anode input pad;
each anode pad in the second group of anode pads is electrically connected with the second anode wire, one end of the second anode wire close to the anode input pad is electrically connected with one end of the second anode leading-out wire through a through hole penetrating the flexible substrate, and the other end of the second anode leading-out wire extends along the length direction of the flexible substrate to be electrically connected with the second anode input pad.

12. The haptic feedback assembly according to claim 11, wherein the first anode input pad, the second anode input pad, and the cathode input pad are sequentially arranged along a width direction of the flexible substrate.

13. The haptic feedback assembly according to claim 12, wherein widths of the flexible substrate at positions of the first anode input pad, the second anode input pad and the cathode input pad are greater than widths of the flexible substrate at remaining positions.

14. The haptic feedback assembly according to claim 7, wherein a first anode pad at the top of the plurality of anode pads arranged along the length direction of the flexible substrate is electrically connected with one end of the anode wire, and a last cathode pad at the end of the plurality of cathode pads arranged along the length direction of the flexible substrate is electrically connected with one end of the cathode wire;
the first metal layer further comprises a plurality of serial connection wires, a previous cathode pad and a next anode pad along the length direction of the flexible substrate are electrically connected through the serial connection wire.

15. The haptic feedback assembly according to claim 14, wherein the other end of the anode wire electrically connected with the first anode pad, at a middle position of a first piezoelectric actuator at the top of the plurality of piezoelectric actuators, is electrically connected with one end of the anode leading-out wire through a through hole penetrating the flexible substrate, and the other end of the anode leading-out wire extends along the length direction of the flexible substrate to be electrically connected with the anode input pad;
the other end of the cathode wire electrically connected with the last cathode pad is electrically connected with one end of the cathode leading-out wire through a through hole penetrating the flexible substrate, and the other end of the cathode leading-out wire extends along the length direction of the flexible substrate to be electrically connected with the cathode input pad.

16. The haptic feedback assembly according to any one of claims 2 to 15, wherein a shape of the piezoelectric actuator comprises a rectangle or a circle.

17. The haptic feedback assembly according to any one of claims 1 to 16, wherein a structure of the piezoelectric actuator is a piezoelectric film or a piezoelectric ceramic block body.

18. A haptic feedback device, comprising the haptic feedback assembly according to any one of claims 1 to 17.

19. The haptic feedback device according to claim 18, further comprising a cover plate, wherein a side of the piezoelectric actuator away from the flexible circuit board is attached to a peripheral region of the cover plate.

20. The haptic feedback device according to claim 19, further comprising a display module, wherein the display module and the haptic feedback assembly are on the same side of the cover plate, and the touch feedback assembly is disposed on the cover plate at at least a side of the display module.

21. The haptic feedback device according to claim 20, wherein the display module is provided with a pair of long sides oppositely arranged and a pair of short sides connected with the pair of long sides, the haptic feedback assembly is disposed between each long side and an adjacent edge of the cover plate, and an extending direction of a long side of the haptic feedback assembly is the same as an extending direction of a long side of the display module.
